(19) Europäisches Patentamt
European Patent Office
Office européen des brevets

(11) Publication number: **0 423 716 A2**

# (12) EUROPEAN PATENT APPLICATION

(21) Application number: **90119824.2**

(22) Date of filing: **16.10.90**

(51) Int. Cl.5: **C08L 63/00**, C08L 21/00

(30) Priority: **19.10.89 US 423909**

(43) Date of publication of application: **24.04.91 Bulletin 91/17**

(84) Designated Contracting States: **AT BE CH DE ES FR GB IT LI NL SE**

(71) Applicant: **THE DOW CHEMICAL COMPANY**
**2030 Dow Center Abbott Road**
**Midland, MI 48640(US)**

(72) Inventor: **Kleweno, Douglas G.**
**124 Lakewood Drive**
**Angleton, Texas 77515(US)**
Inventor: **Wang, Chun S.**
**No. 2 Lane 365 Hsi-Men Road, Section 2**
**Tainan(TW)**
Inventor: **Hoffman, Dwight K.**
**1206 Kingsbury Court**
**Midland, Michigan 48640(US)**

(74) Representative: **Sternagel, Hans-Günther, Dr. et al**
**Patentanwälte Dr. Michael Hann Dr. H.-G. Sternagel Sander Aue 30**
**W-5060 Bergisch Gladbach 2(DE)**

## (54) Epoxy resin blends and curable compositions containing same.

(57) Blends comprising (A) at least one unsaturated hydrocarbon-phenol epoxy resin having an average of more than two vicinal epoxy groups per molecule; (B) at least one compound having an average of more than two vicinal epoxy groups per molecule and which is different from component (A); (C) optionally, at least one compound having an average of more than one, but not more than two vicinal epoxy groups per molecule and, (D) at least one rubber or elastomer; and wherein component (C) is present in an amount such that from zero to less than 20 percent of the total amount of vicinal epoxy groups contained in components (A), (B) and (C) is contributed by component (C) are useful in formulations for encapsulating electrical components.

EP 0 423 716 A2

## EPOXY RESIN BLENDS AND CURABLE COMPOSITIONS CONTAINING SAME

The present invention pertains to blends containing epoxy compounds containing an average of more than two vicinal epoxy groups per molecule, epoxidized hydrocarbon-phenol resins and rubbers or elastomers and to curable compositions containing same.

Blends of epoxy novolac resins and rubber have been suggested for use in electrical or electronic encapsulants as disclosed by Hoffman et al. in U.S. Patent No. 4,708,996. Such blends have been stated to improve the toughness of the electrical or electronic encapsulation formulations. Applicants have found that these blends do indeed improve the toughness of the electrical or electronic encapsulation formulations. However, it would also be desirable to have electrical or electronic encapsulation compositions which not only possess an improvement in toughness, but also would exhibit low stress and reduced moisture absorption as evidenced by lower failure rates when subjected to thermal shock testing and accelerated device reliability testing under a pressurized steam environment.

One aspect of the present invention pertains to a blend comprising

(A) at least one unsaturated hydrocarbon-phenol epoxy resin having an average of more than two vicinal epoxy groups per molecule;

(B) at least one compound having an average of more than two vicinal epoxy groups per molecule and which is different from component (A);

(C) optionally, at least one compound having an average of more than one, but not more than two vicinal epoxy groups per molecule and

(D) at least one rubber or elastomer; and wherein component (C) is present in an amount such that from zero to less than 20 percent of the total amount of vicinal epoxy groups contained in components (A), (B) and (C) is contributed by component (C).

Another aspect of the present invention is directed to a process for preparing the aforementioned blend.

Another aspect of the present invention pertains to a curable composition comprising the aforementioned blend and a curing amount of at least one curing agent therefor.

Another aspect of the present invention is directed to a process for preparing the aforementioned curable composition.

Another aspect of the present invention pertains to the product resulting from curing the aforementioned curable composition.

Another aspect of the present invention is directed to a process for preparing the aforementioned product.

Another aspect of the present invention pertains to an electrical or electronic component encapsulated in the aforementioned curable composition which is subsequently cured.

Another aspect of the present invention is directed to a process for preparing the above electrical or electronic component.

The present invention provides epoxy-containing compositions which when employed as an electrical component encapsulating composition and cured result in electrical devices which exhibit low stress and reduced moisture absorption as evidenced by lower failure rates when subjected to thermal shock testing and accelerated device reliability testing under a pressurized steam environment.

The blends of the present invention can be prepared by any suitable means, for example, (a) by blending a mixture of the components (A) + (B) + (C), when present, and (D); (b) by blending the rubber or elastomer, component (D), with one of the epoxy components (A), (B) or (C), when present, followed by blending that mixture with the other epoxy component(s) which was (were) not blended with the rubber or elastomer, component (D); or (c) by blending each of the epoxy components (A), (B) and (C), when present with portions of the rubber component and then blending the epoxy components containing rubber with each other.

The components (A), (B), (C), when present, and (D) can be blended in any desired proportion. Suitable such proportions include from 1 to 99, more suitably from 25 to 75, most suitably from 40 to 60 percent by weight of either of the epoxy components (A) or (B) and suitably from 99 to 1, more suitably from 75 to 25, most suitably from 60 to 40 percent by weight of the other epoxy component (A) or (B). The rubber or elastomer, component (D), can be suitably employed in amounts of from 1 to 30, more suitably from 5 to 25, most suitably from 8 to 20 percent by weight based upon the combined weight of the two epoxy components (A) and (B) and the rubber or elastomer component (D).

If desired, the blend can contain a third epoxy component, component (C), which is employed in an amount from 0 to 20, preferably from 1 to 15, more preferably from 2 to 15, most preferably from 5 to 12 percent of the epoxy groups contained in a blend of components (A), (B) and (C) is contributed by

component (C).

The blends can be prepared at any temperature which facilitates adequate mixing, for example, at temperatures of from 90 °C to 250 °C, more suitably from 110 °C to 230 °C, most suitably from 130 °C to 200 °C.

Any suitable blending means for preparing the blends of the present invention can be employed, for example, kneader, static mixer, extruder, roll mill, agitator or combinations thereof.

Suitable hydrocarbon-phenol epoxy resins which can be employed herein include those disclosed by Vegter et al. in U.S. Patent No. 3,536,734, by Nelson in U.S. Patent No. 4,390,680 and by Nelson et al. in U.S. Patent No. 4,394,497. Particularly suitable hydrocarbon-phenol epoxy resins include those prepared by dehydrohalogenating the reaction product of an epihalohydrin and the reaction product of an aromatic shydroxyl-containing compound with an unsaturated hydrocarbon having from 4 to 55 carbon atoms. Suitable aromatic hydroxyl-containing compounds which can be employed herein include any such compounds which contain one or two aromatic rings, at least one phenolic hydroxyl group and at least one ortho or para ring position with respect to a hydroxyl group available for alkylation.

Particularly suitable aromatic hydroxyl-containing compounds which can be employed herein include, for example, phenol, chlorophenol, bromophenol, methylphenol, hydroquinone, catechol, resorcinol, guaiacol, pyrogallol, phloroglucinol, isopropylphenol, ethylphenol, propylphenol, t-butylphenol, isobutylphenol, octylphenol, nonylphenol, cumylphenol, p-phenylphenol, o-phenylphenol, m-phenylphenol, bisphenol A, dihydroxydiphenyl sulfone and mixtures thereof.

Suitable unsaturated hydrocarbons which, either in a crude or purified state, can be employed herein include, for example, butadiene, isoprene, piperylene, cyclopentadiene, cyclopentene, 2-methylbutene-2, cyclohexene, cyclohexadiene, methyl cyclopentadiene, dicyclopentadiene, limonene, dipentene, linear and cyclic dimers of piperylene, methyl dicyclopentadiene, dimethyl dicyclopentadiene, norbornene, norbornadiene, ethylidine norbornene and mixtures thereof. Also suitable unsaturated hydrocarbons include the other dimers, codimers, oligomers and cooligomers of the aforementioned unsaturated hydrocarbons. Particularly suitable unsaturated hydrocarbons which can be employed herein include, for example, a dicyclopentadiene concentrate containing from 70 to 100 percent by weight of dicyclopentadiene; from 0 to 30 percent by weight of $C_8$-$C_{12}$ dimers or codimers of $C_4$-$C_6$ dienes such as, cyclopentadieneisoprene, cyclopentadienepiperylene, cyclopentadienemethyl cyclopentadiene, and/or dimers of isoprene, piperylene and methyl cyclopentadiene from zero to 7 percent by weight of $C_{12}$-$C_{18}$ trimers of $C_4$-$C_6$ dienes and from zero to 10 percent by weight of aliphatic diolefins such as, for example, piperylene, isoprene, 1,5-hexadiene and cyclic olefins such as cyclopentadiene, methyl cyclopentadiene and cyclopentene. Methods of preparation for these dicyclopentadiene concentrates and more detailed descriptions thereof can be found collectively in U.S. Patent No. 3,557,239 issued to Gebhart et al. and U.S. Patent No. 4,167,542 issued to Nelson.

Also, particularly suitable unsaturated hydrocarbons which can be employed herein include a crude dicyclopentadiene stream containing from 20 to 70 percent by weight dicyclopentadiene, from 1 to 10 percent codimers and dimers of $C_4$-$C_6$ hydrocarbons (described above), from zero to 10 percent oligomers of $C_4$-$C_6$ dienes and the balance to provide 100 percent, $C_4$-$C_6$ alkanes, alkenes and dienes.

Also, particularly suitable unsaturated hydrocarbons which can be employed herein include a crude piperylene or isoprene stream containing from 30 to 70 percent by weight piperylene or isoprene, zero to ten percent by weight $C_8$-$C_{12}$ dimers and codimers of $C_4$-$C_6$ dienes, and the balance to provide 100 percent $C_4$-$C_6$ alkanes, alkenes and dienes.

Also, particularly suitable are hydrocarbon oligomers prepared by polymerization of the reactive components in the above hydrocarbon streams, for example, dicyclopentadiene concentrate, crude dicyclopentadiene, crude piperylene or isoprene, individually or in combination with one another or in combination with high purity diene streams.

Preferably the hydrocarbon-phenol epoxy resins employed herein are those represented by the following general formula I:

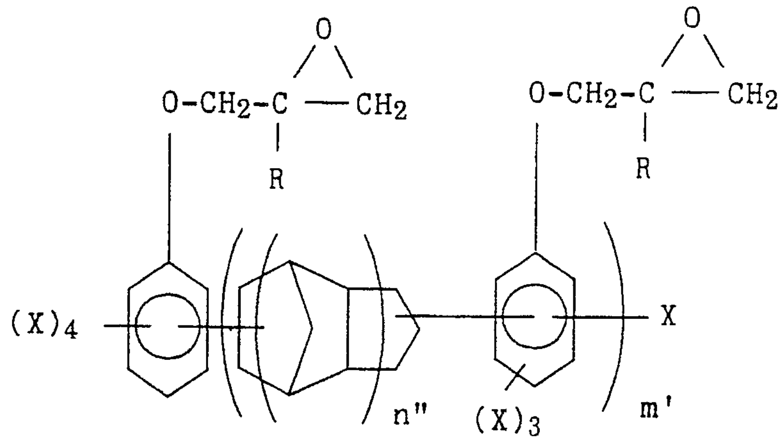

wherein each R is independently hydrogen or an alkyl group having from 1 to 4 carbon atoms; each X is independently hydrogen, a hydrocarbyl group or substituted hydrocarbyl group having suitably from 1 to 10, more suitably from 1 to 6, most suitably from 1 to 3 carbon atoms, a halogen atom, particularly chlorine or bromine, or a nitro group; m′ has a value suitably from 1.01 to 12, more suitably from 2 to 6, most suitably from 2 to 3; and n″ has an average value suitably from 1 to 12, more suitably from 1 to 6, most suitably from 1 to 3.

The term "hydrocarbyl" as employed herein means any aliphatic, cycloaliphatic, aromatic, aryl substituted aliphatic or cycloaliphatic, or aliphatic or cycloaliphatic substituted aromatic groups. The term "substituted" means that the hydrocarbyl group can be substituted with halogen atoms, particularly chlorine or bromine, or nitro groups.

Suitable compounds having an average of more than two vicinal epoxy groups per molecule, component (B), and which are different from the hydrocarbon-phenol epoxy resin, component (A), which can be employed herein include, for example, the polyglycidyl ethers of compounds containing three aromatic hydroxyl groups per molecule, the polyglycidyl ethers of phenol-aldehyde resins, the polyglycidyl ethers of substituted phenol aldehyde resins wherein such substituent groups on the phenol include, for example, alkyl, alkenyl, aryl, aralkyl, alkaryl, $NO_2$ and halogen (preferably chlorine or bromine). The substituent groups can contain from 1 to 8, preferably from 1 to 3, more preferably from 1 to 2. Such epoxy-containing compounds of component (B) which can be employed herein include, but are not limited to epoxy resins represented by the following general formulas II and III:

Formula II

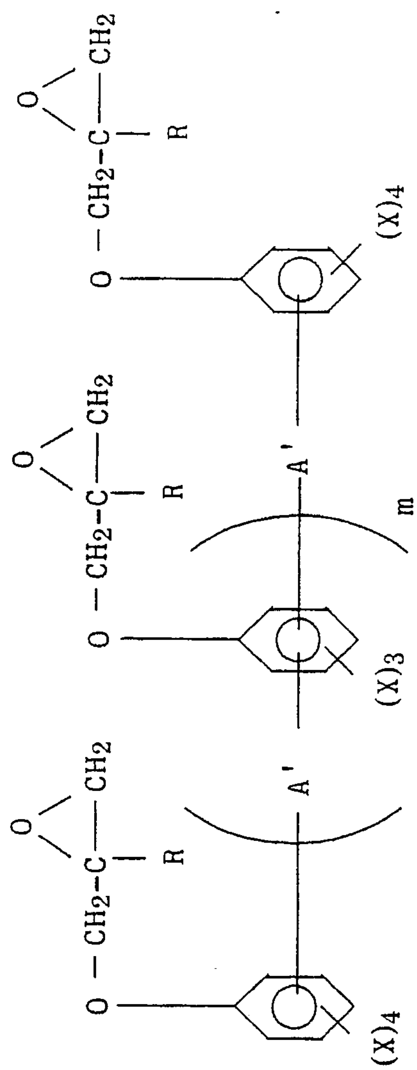

Formula III

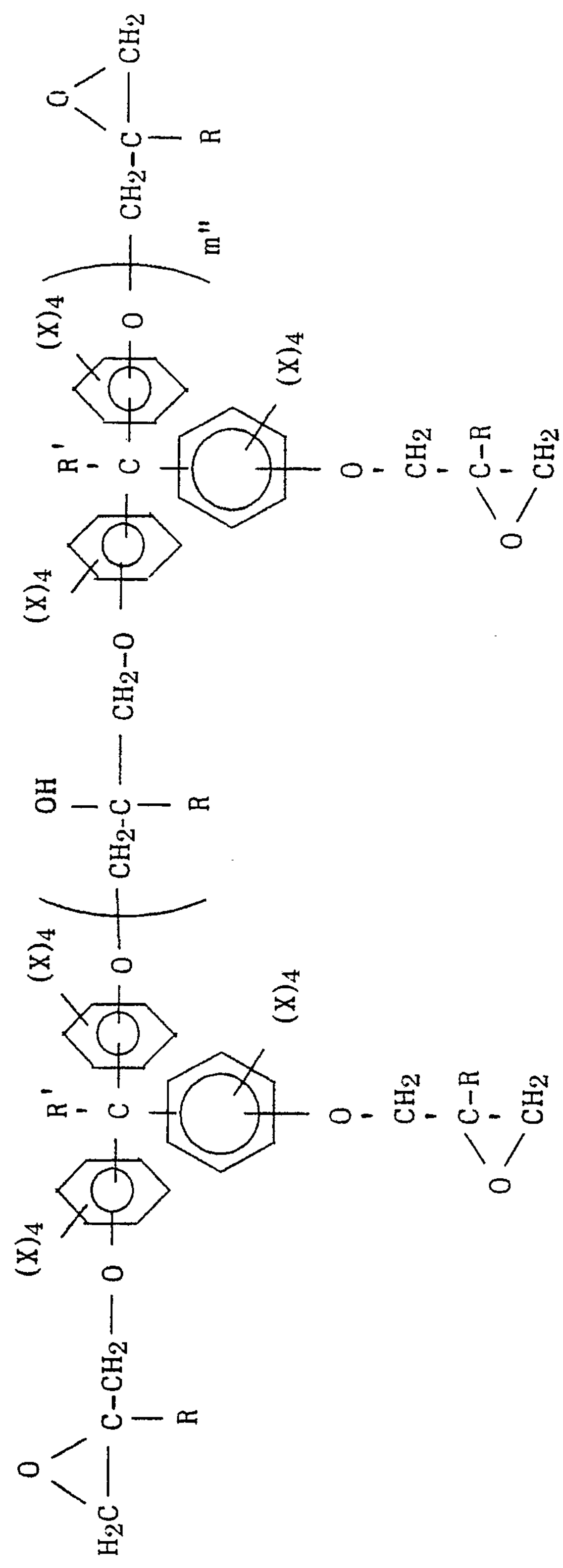

wherein each A′ is independently a divalent hydrocarbyl or substituted hydrocarbyl group having suitably from 1 to 12, more suitably from 1 to 6, most suitably from 1 to 3 carbon atoms; each R is independently hydrogen or san alkyl group having from 1 to 4 carbon atoms; each R′ is independently hydrogen or a monovalent hydrocarbyl group or substituted monovalent hydrocarbyl group having suitably from 1 to 4, more suitably from 1 to 3, most suitably from 1 to 2 carbon atoms; each X is independently hydrogen, a hydrocarbyl group or substituted hydrocarbyl group having suitably from 1 to 10, more suitably from 1 to 6, most suitably from 1 to 3 carbon atoms, a halogen atom, particularly chlorine or bromine, or a nitro group;

m has a value suitably from 0.01 to 12, more suitably from 1 to 6, most suitably from 1 to 3 and m″ has an average value suitably from zero to 10, more suitably from zero to 5, most suitably from zero to 2.

If desired, the compositions of the present invention can contain minor amounts of, component (C), a compound containing an average of more than one, but not more than about two vicinal epoxy groups per molecule. Suitable such component (C) compounds which can be employed herein include, for example, the diglycidyl ethers of compounds containing two aromatic hydroxyl groups per molecule, two aliphatic hydroxyl groups per molecule, two cycloaliphatic groups per molecule or compounds containing one aromatic hydroxyl group per molecule and one aliphatic hydroxyl group per molecule. Suitable component (C) compounds include, for example, those represented by the following formulas IV, V or VI:

Formula IV

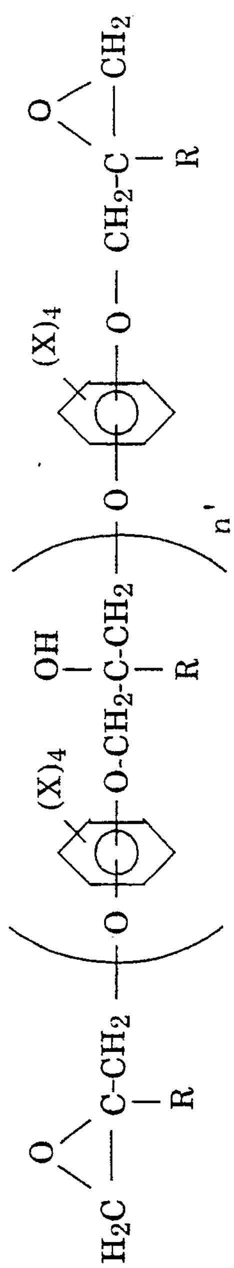

Formula V

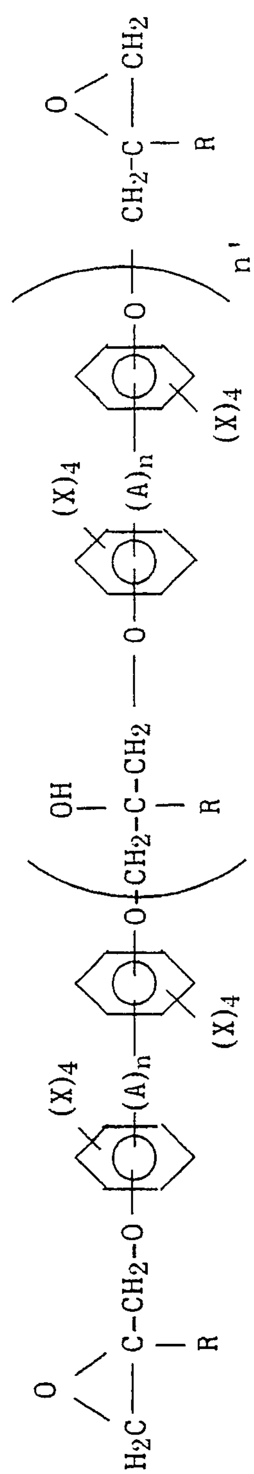

Formula VI

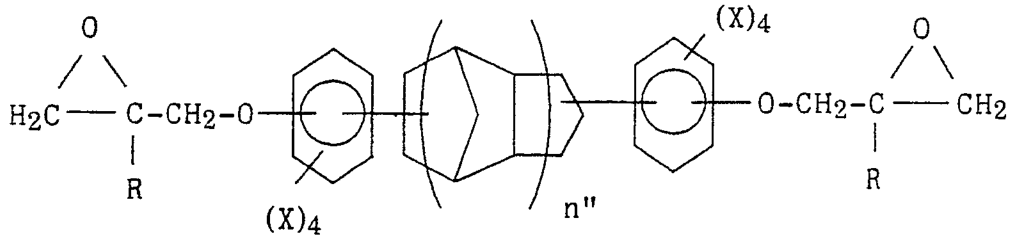

wherein A is a divalent hydrocarbyl group having suitably from 1 to 12, more suitably from 1 to 6, most suitably from 1 to 3 carbon atoms, -O-, -S-, -S-S-, -SO-, $-SO_2-$, -CO- or -O-CO-O-; each R is independently hydrogen or an alkyl group having from 1 to 4 carbon atoms; each X is independently hydrogen, a hydrocarbyl group or substituted hydrocarbyl group having suitably from 1 to 10, more suitably from 1 to 6, most suitably from 1 to 3 carbon atoms, a halogen atom, particularly chlorine or bromine, or a nitro group; n has a value of zero or 1; $n'$ has an average value suitably from zero to 3, more suitably from zero to 1.5, most suitably from zero to 0.5; and $n''$ has an average value suitably from 1 to 12, more suitably from 1 to 6, most suitably from 1 to 3.

Particularly suitable component (C) compounds which can be employed herein include, for example, the diglycidyl ethers of bisphenols such as bisphenol A, bisphenol F, bisphenol K, bisphenol S, dihydroxybiphenyl, as well as the halogenated and alkyl derivatives thereof such as chlorine, bromine and alkyl derivatives having from 1 to 4 carbon atoms. These diglycidyl ethers having an average of more than one but not more than two glycidyl ether groups per molecule suitably have an epoxide equivalent weight (EEW) of from 170 to 600, more suitably from 170 to 360, most suitably from 170 to 250.

Component (C) compounds are present in quantities such that less than 20, preferably from 1 to 20, more preferably from 2 to 15, most preferably from 5 to 12, percent of the epoxide groups contained in all of the epoxy-containing compounds are derived from said compound or compounds having an average of more than one but not more than two vicinal epoxy groups per molecule.

Suitable rubbers or elastomers, component (D), which can be employed herein include, for example, carboxyl-containing rubbers or elastomers, copolymers of alkyl acrylates or methacrylates or alkyl esters of other alpha-alkyl substituted ethylenically unsaturated acids, glycidyl acrylate or glycidyl methacrylate, or grafted rubber particles characterized by having a rubbery core and a grafted polymer shell which is compatible with epoxy resins. Particularly suitable component (D) compounds are the carboxyl-containing butadiene/acrylonitrile rubbers or elastomers. Other rubbers or elastomers which can be employed similarly include poly(butadiene/acrylonitrile) copolymers which contain terminal or pendant amine groups. These rubbers or elastomers containing secondary amine groups, or carboxyl-containing moieties are commercially available from the B. F. Goodrich Company under the tradename HYCARTM.

Particularly suitable rubbers or elastomers which can be similarly employed include polymers formed by polymerizing monomers, such as alkyl acrylate and alkylmethacrylate, in situ in the epoxy resin in the presence of a stabilizer to form a stable dispersed polymer phase according to the methods disclosed by D. K. Hoffman and C. Arends in U.S. Patent No. 4,789,712 and also by R. E. Adam et al. in U.S. Patent No. 54,524,181.

Another particularly suitable form of component (D) for modification of the epoxy resins of the present invention includes those available in the form of a rubber-modified epoxy composition comprising (1) an epoxy resin continuous phase and (2) a stabilized discontinuous phase of grafted rubber particles, which particles have a resin-insoluble rubbery core with a shell which is compatible with the epoxy phase but has latent reactivity with a curing agent. These grafted rubber concentrates (GRC) can be prepared by the methods described by D. E. Henton, C. B. Arends, D. M. Pickelman and V. E. Meyer in U.S. Patent No. 4,778,851. Preferred grafted rubber compositions have, as the rubbery core components, conjugated dienes such as butadiene and isoprene, acrylate rubbers such as 2-ethylhexyl acrylate and butyl acrylate rubber and interpolymers. Particularly preferred cores are cores of crosslinked butadiene rubber. Preferred compounds for the grafted shell are polymers of ethylenically unsaturated compounds such as styrenics, acrylates and methacrylates, acrylonitrile, acrylic and methacrylic acid, vinylized glycidyl ethers such as glycidyl acrylate and methacrylate and combinations thereof. The shell compounds contain a functionality which reacts with functionalities of the epoxy resin continuous phase.

These rubber or elastomer modifiers can be employed in any suitable amount. Such amounts can include, for example, suitably from 1 to 30, more suitably from 5 to 25, most suitably from 8 to 20 percent by weight based upon the total weight of the epoxy compounds and the rubber or elastomer compounds.

The curable compositions of the present invention can contain a curing quantity of any suitable curing agent for epoxy resins. Suitable such curing agents include, for example, primary and secondary polyamines, carboxylic acids and anhydrides thereof, phenolic hydroxyl-containing compounds, guanidines, biguanides, urea-aldehyde resins, melamine-aldehyde resins, alkoxylated urea-aldehyde resins, alkoxylated melamine-aldehyde resins, amides, sulfones, sulfonamides and combinations thereof. Particularly suitable curing agents include, for example, phenol-formaldehyde novolac resins, cresol-formaldehyde novolac resins, dicyclopentadiene-phenol resins, dicyclopentadiene-cresol resins, bis-(4-aminophenyl)sulfone, aminophenyl sulfonamide, dicyandiamide, phenylenediamine, phthalic anhydride and combinations thereof. The curing agents are employed in an amount which will effectively cure the curable compositions of the present invention. These amounts will depend upon the particular modified epoxy resin and curing agent employed; however, suitable amounts include, for example, from 0.5 to 2.0, more suitably from 0.7 to 1.5, most suitably from 0.9 to 1.2 equivalents of curing agent per epoxide equivalent for those curing agents which cure by reacting with the epoxy group of the epoxy resin or per hydroxyl group for those curing agents which cure by reacting with the aliphatic hydroxyl groups along the backbone of the epoxy resin. The Handbook of Epoxy Resins by Lee and Neville, McGraw-Hill, 1967, contains various discussions concerning the curing of epoxy resins as well as compilation of suitable curing agents.

If desired, other components or additives can be included in the blends of the present invention, for example, pigments, dyes, fillers, wetting agents, stabilizers, mold release agents, flow control agents, fire retardant agents, surfactants and combinations thereof.

These additives are added in functionally equivalent amounts, for example, the pigments and/or dyes are added in quantities which will provide the composition with the desired color; however, they are suitably employed in amounts of from zero to 20, more suitably from 0.05 to 5, most suitably from 0.5 to 3 percent by weight based upon the weight of total blended composition.

Fillers are employed in amounts which will provide the composition with the desired consistency; however, they are suitably employed in amounts of from zero to 95, more suitably from 10 to 80, most suitably from 40 to 75 percent by weight based upon the weight of total composition.

The compositions of the present invention can also, if desired, contain reinforcing materials in the form of mats, woven fabric, unidirectional fibers, rovings, random fibers or filaments, inorganic fillers, inorganic whiskers, hollow spheres and ceramics. These reinforcing materials can be prepared from glass fibers, aramid fibers, graphite fibers, and polymer fibers such as nylon, polyalkylene terephthalate, polyethylene and polypropylene, polyesters and combinations thereof.

The compositions of the present invention can be employed in formulations for encapsulants, coatings, castings, laminates, composites and potting. The compositions are particularly suitable for use in formulations for encapsulating electrical components in that they provide such components having low stress and reduced moisture absorption rendering them better suited for higher temperature and moisture environments.

The following examples are illustrative of the invention, but are not to be construed as to limiting the scope thereof in any manner.

## Example 1

### A. Preparation of Rubber Modified Epoxy Resin.

500 grams of a cresol-formaldehyde epoxy novolac resin having an EEW of 194 and a viscosity of 300 centistokes (0.000300 $m^2/s$) at 150 °C was charged into a five-neck, one-liter, round bottom flask equipped with a dual syringe pump for vinyl monomer addition, means for initiator addition, stirring means, condenser, thermometer and nitrogen/air sparge. The epoxy resin was heated to 120 °C with stirring at which point 6.25 grams of methacrylic acid was added continuously followed by the addition of 0.01 gram of hydroquinone as an inhibitor and 0.21 gram of a 70 weight percent solution of ethyltriphenyl phosphonium acetate•acetic acid complex in methanol. The mixture was heated at 120 °C with air sparge over a period of 10 minutes. To the resulting precursor mixture was added, at a temperature of 120 °C, a monomer mixture of 111.8 grams of 2-ethylhexyl acrylate and 5.9 grams of glycidyl methacrylate over a one hour period. Over the one hour period that the two monomers were added, a mixture of 1.25 grams of

tertiarybutyl peroctoate and 0.63 grams of tertiarybutyl perbenzoate was added to the precursor mixture. The total mixture was reacted at a 120 °C for an additional two hours. The resulting mixture was then placed on a rotary evaporator to remove a light fraction at 175 °C and full vacuum to yield a rubber or elastomer modified cresol-formaldehyde epoxy novolac resin product containing 20 percent rubber or elastomer by weight. The resultant rubber modified epoxy resin had an epoxide equivalent weight (EEW) of 250 and a viscosity of about 500 centistokes (0.000500 $m^2/s$) at 150 °C.

B. Preparation of Epoxy Resin Blend

The epoxy resin, 100 parts by weight (pbw) (0.4 epoxy equivalent), prepared in A above and 100 pbw (0.51 epoxy equivalent) of a cresol-formaldehyde epoxy novolac resin having an EEW of 195 and an average functionality of 6 were blended at a temperature of 170 °C for one hour. The resultant homogeneous blend had an EEW of 223.

C. Preparation of Epoxy Resin Blend.

The epoxy resin, 100 parts by weight (pbw) (0.4 epoxy equivalent), prepared in A above and 100 pbw (0.4 epoxy equivalent) of an epoxidized dicyclopentadiene-phenol resin having an EEW of 250 and an average functionality of 3.2 were blended at a temperature of 170 °C for one hour. The resultant homogeneous blend had an EEW of 250.

D. Preparation of Epoxy Resin Blend

The epoxy resin, 100 parts by weight (pbw) (0.51 epoxy equivalent), of a cresol-formaldehyde epoxy novolac resin having an EEW of 195 and an average functionality of 6, and 100 pbw (0.04 epoxy equivalent) of an epoxidized dicyclopentadiene-phenol resin having an EEW of 250 and an average functionality of 3.2 were blended at a tmeperature of 170 °C for an hour. The resultant homogeneous blend had an EE of 223.

E. Preparation of Epoxy Resin Blend

The epoxy resin, 75 parts by weight (pbw) (0.4 epoxy equivalent), prepared in A above and 25 pbw (0.4 epoxy equivalent) of an epoxidized dicyclopentadiene-phenol resin having an EEW of 250 and an average functionality of 3.2 were blended at a temperature of 170 °C for one hour. The resultant homogeneous blend had an EEW 252.

F. Preparation of Encapsulant Formulation

Encapsulant compositions were prepared by blending the epoxy resin blends of parts B, C, D or E with the other components listed in Table I. The dry blend was subsequently mixed at a temperature of 90 °C on a two-roll mill over a period of 7 minutes. The formulations were then cured at 175 °C for 4 hours and then subjected to physical testing.

TABLE I

| | COMPONENT | FORMULATION NO. (grams) | | | | |
|---|---|---|---|---|---|---|
| | | I* | II* | III | IV* | IV |
| 1 | Epoxy 1[a] | 168.5 | ----- | ----- | ----- | ----- |
| 2 | Epoxy 2[b] | ---- | 175.8 | ----- | ----- | ----- |
| 3 | Epoxy 3[c] | ---- | ---- | 182.9 | ----- | ----- |
| 4 | Epoxy 4[d] | ---- | ---- | ---- | 176.5 | ---- |
| 5 | Epoxy 5[e] | ---- | ---- | ---- | ---- | 183.2 |
| 6 | Epoxy 6[f] | 26.3 | 26.3 | 26.3 | 26.3 | 26.3 |
| 7 | Curing Agent[g] | 96.2 | 89.0 | 79.2 | 88.3 | 81.5 |
| 8 | Catalyst[h] | 2.0 | 2.0 | 2.0 | 2.0 | 2.0 |
| 9 | Mold Release[i] | 4.0 | 4.0 | 4.0 | 4.0 | 4.0 |
| 10 | Coupling Agent[j] | 4.0 | 4.0 | 4.0 | 4.0 | 4.0 |
| 11 | Filler 1[k] | 685.0 | 685.0 | 685.0 | 685.0 | 685.0 |
| 12 | Filler 2[l] | 10.0 | 10.0 | 10.0 | 10.0 | 10.0 |
| 13 | Filler 3[m] | 4.0 | 4.0 | 4.0 | 4.0 | 4.0 |

Footnotes to Table I.

* Not an example of the present invention.
**a** Epoxy 1 is a cresol-formaldehyde novolac epoxy resin having an EEW of 195, an average epoxide functionality of 7 and a viscosity of 420 centistokes (0.000420 $m^2/s$) at 150 °C.
**b** Epoxy 2 is the Rubber or Elastomer modified epoxy resin prepared in Part B of Example 1.
**c** Epoxy 3 is the blend of epoxy resins prepared in Part C of Example 1.
**d** Epoxy 4 is the blend of epoxy resins prepared in Part D of Example 1.
**e** Epoxy 5 is the blend of epoxy resin prepared in Part E of Example 1.
**f** Epoxy 6 is the diglycidyl ether of tetrabromobisphenol A having an EEW of 465 and a bromine content of 47.6 percent by weight.
**g** The curing agent is a phenol-formaldehyde novolac resin having an average hydroxyl functionality of 6 and a phenolic hydroxyl equivalent weight of 104.
**h** The catalyst is triphenylphosphine.
**i** The mold release agent is refined Montan OP&E wax commercially available from Hoechst Celanese.
**j** The coupling agent is an epoxy silane commercially available from Dow Corning as Z-6040.
**k** Filler 1 is fused silica commercially available from Harbison-Walker as GP-71.
**l** Filler 2 is antimony trioxide commercially available from Amspec Chemical Corp.
**m** Filler 3 is carbon black commercially available from Degussa Corp. as lamp Black 101.
**n** All formulations contained 1.25 percent bromine by weight.

Example 2

The formulations in Table 1 were subjected to several physical tests. These tests and results are given in Table II.

TABLE II

| TEST METHOD | PHYSICAL PROPERTY | UNIT | FORMULATION NO. | | | | |
|---|---|---|---|---|---|---|---|
| | | | I* | II* | III | IV | V |
| ASTM C790-84A | Flexural Modulus | Mpsi | 2.10 | 1.82 | 1.93 | 2.02 | 1.75 |
| | | GPa | 14.5 | 12.5 | 13.3 | 13.9 | 12.0 |
| ASTM C790-84A | Flexural Strength | kpsi | 20.2 | 18.6 | 18.5 | 20.2 | 18.5 |
| | | MPa | 139.3 | 128.2 | 127.6 | 139.3 | 127.3 |
| ASTM C790-84A | Strain at Failure | percent | 1.03 | 1.18 | 1.09 | 1.08 | 1.25 |
| ASTM D638-82A | Tensile Modulus | Mpsi | 2.19 | 1.98 | 1.94 | 2.10 | 1.77 |
| | | GPa | 15.1 | 13.6 | 13.4 | 14.5 | 12.2 |
| ASTM D638-82A | Tensile Strength | Kpsi | 13.4 | 11.0 | 12.7 | 13.0 | 12.6 |
| | | MPa | 92.4 | 75.8 | 87.6 | 89.6 | 87.7 |
| ASTM D638-82A | Elongation at Failure | percent | 0.81 | 1.07 | 0.97 | 0.90 | 1.00 |
| ASTM E399-83 | $K_{1c}$a | kpsi-in$^{\frac{1}{2}}$ | 1.71 | 2.03 | 2.23 | 1.65 | 2.05 |
| | | MPa-m$^{\frac{1}{2}}$ | 1.88 | 2.23 | 2.56 | 1.81 | 2.25 |
| ASTM E399-83 | $G_{1c}$b | in-lb/in$^2$ | 1.22 | 1.89 | 2.33 | 1.18 | 2.24 |
| | | kJ/m$^2$ | 30.8 | 48.2 | 58.7 | .207 | .392 |
| TMA$^c$ ASTM E831-86 | Glass Transition Temp. | °C | 166 | 166 | 158 | 158 | 158 |
| TMA$^c$ ASTM E831-86 | Thermal Expansion below Tg 60°C -to 100°C | µm/m°C | 25 | 27 | 24 | 24 | 24 |
| TMA$^c$ ASTM E831-86 | Thermal Expansion above Tg 180°C to 220°C | µm/m°C | 75 | 81 | 64 | 73 | 89 |

FOOTNOTES TO TABLE II

* Not an example of the present invention.

**a** Plane-Strain Fracture Toughness, $K_{1c}$, characterizes the resistance of a material to fracture in a neutral environment in the presence of a sharp crack under severe tensile constraint.

**b** Critical Fracture Energy Release Rate, $G_{1c}$, is a measure of the total amount of energy dissipated during crack growth. In the plane-strain condition, calculation of the Gic value requires Poisson's Ratio to be known. Since Poisson's Ratio has not been measured for these materials, it is assumed to be 0.3 for these tests. This value is obtained by review of the literature for molding compounds in which the Poisson's Ratio had been measured.

**c** Thermal Mechanical Analysis.

Example 3

The encapsulation formulations of Table I were subjected to moisture absorption by placing preweighed 1/16 inch thick x 4 inch diameter (1.5875 mm x 101.6 mm) cured disks in an autoclave at 15 psig (103.422 kPa) steam pressure at 121 °C for 100 hours and 1,000 hours. The disks were removed and are cooled to ambient temperature for about 15 to 30 minutes. Then the disks were wiped dry and again weighed to determine any weight difference. The results are given in Table III.

TABLE III

| FORMULATION NO. | MOISTURE PICKUP | |
|---|---|---|
| | 100 hours | 1,000 hours |
| I* | 0.77 | 1.29 |
| II* | 0.85 | 1.38 |
| III | 0.75 | 1.24 |
| IV* | 0.61 | 1.15 |
| V | 0.77 | 1.28 |

* Not an example of the present invention.

Example 4

The formulations of Table I were used to encapsulate semiconductor lead frames by the transfer molding method. These devices were subjected to repeated thermal shock cycling from liquid to liquid baths maintained at -65 °C and 150 °C, respectively. The devices were cycled with a 10 minute total cycle time and a 15 second interval between baths. The devices were inspected at periodic intervals for visible cracks in the transfer molding compounds. The results are given in Table IV.

TABLE IV

| THERMAL SHOCK | FORMULATION NO. | | | | |
|---|---|---|---|---|---|
| Cycles | I* (Percent Failure) | II* (percent Failure) | III (Percent Failure) | IV* (percent Failure) | V (Percent Failure) |
| 250 | 11 | 0 | 0 | 7 | 0 |
| 500 | 29 | 10 | 3 | 23 | 0 |
| 750 | 38 | 15 | 7 | 30 | 0 |
| 1000 | 50 | 19 | 11 | 50 | 0 |
| 1500 | 58 | 35 | 21 | 63 | 4 |
| 2000 | 70 | 40 | 31 | 70 | 4 |
| 2500 | 80 | 47 | 33 | 77 | 21 |
| 3000 | --- | 60 | 33 | --- | 21 |
| 3500 | --- | 70 | 41 | --- | 29 |
| 4000 | --- | 81 | 48 | --- | 32 |

* Not an example of the present invention.

Example 5

14-pin LF 412 dual operational amplifiers with a single passivation layer were encapsulated with formulations heretofore designated as I, II and III. They were tested for reliability by placing the encapsulated devices in 139° C and 38 psig (262 kPa) steam environment. The number of hours to 50 percent failure is recorded in the following Table V.

TABLE V

| FORMULATION NO. | HOURS TO 50 PERCENT FAILURE |
|---|---|
| I* | 450 |
| II* | 400 |
| III | 800 |
| IV* | 1000 |
| V | 800 |

* Not an example of the present invention.

## Claims

1. A blend comprising
(A) at least one unsaturated hydrocarbon-phenol epoxy resin having an average of more than two vicinal epoxy groups per molecule;

(B) at least one compound having an average of more than two vicinal epoxy groups per molecule and which is different from component (A);

(C) optionally, at least one compound having an average of more than one, but not more than two vicinal epoxy groups per molecule and

(D) at least one rubber or elastomer; and

wherein component (C), when present, is employed in an amount such that from zero to less than 20 percent of the total amount of vicinal epoxy groups contained in components (A), (B) and (C) is contributed by component (c).

2. A blend of Claim 1 wherein

(a) component (A) is present in an amount of from 1 to 99 percent by weight based upon the combined amount of components (A) and (B);

(b) component (B) is present in an amount of from 99 to 1 percent by weight based upon the combined amount of components (A) and (B);

(c) component (C) is present in an amount of from 1 to 20 percent of the total amount of vicinal epoxy groups contained in components (A), (B) and (C) is contributed by component (C); and

(d) component (D) is present in an amount of from 1 to 30 percent by weight based upon the combined weight of components (A), (B), (C) and (D)

3. A blend of Claim 1 wherein

(a) component (A) is a compound or mixture of compounds represented by the following general formula I:

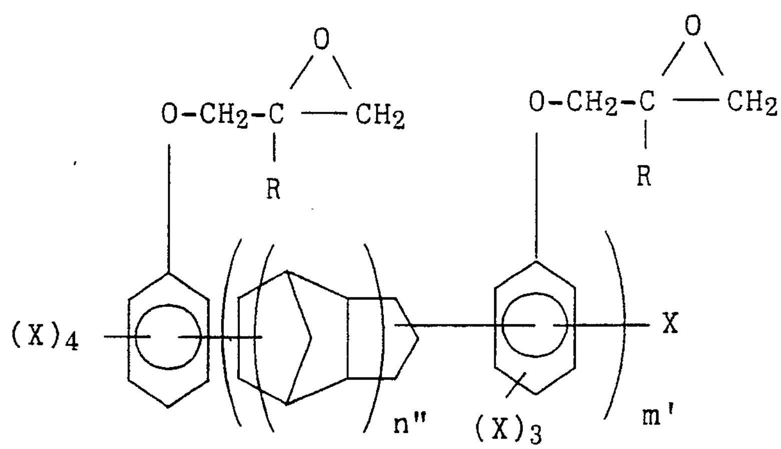

wherein each R is independently hydrogen or an alkyl group having from 1 to 4 carbon atoms; each X is independently hydrogen, a hydrocarbyl group or substituted hydrocarbyl group having from 1 to 10 carbon atoms, a halogen atom, or a nitro group; $m'$ has a value from 1.01 to 12; and $n''$ has an average value from 1 to 12;

(b) component (B) is a compound or mixture of compounds represented by the following general formulas II and III:

Formula II

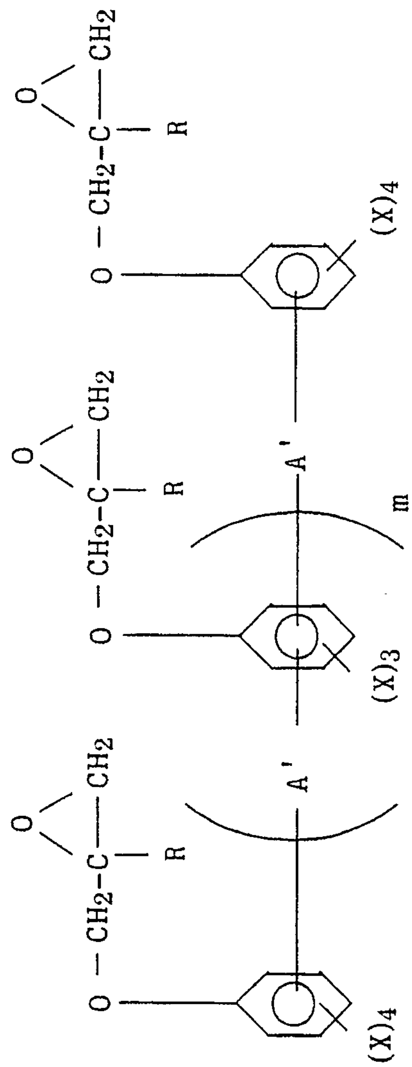

Formula III

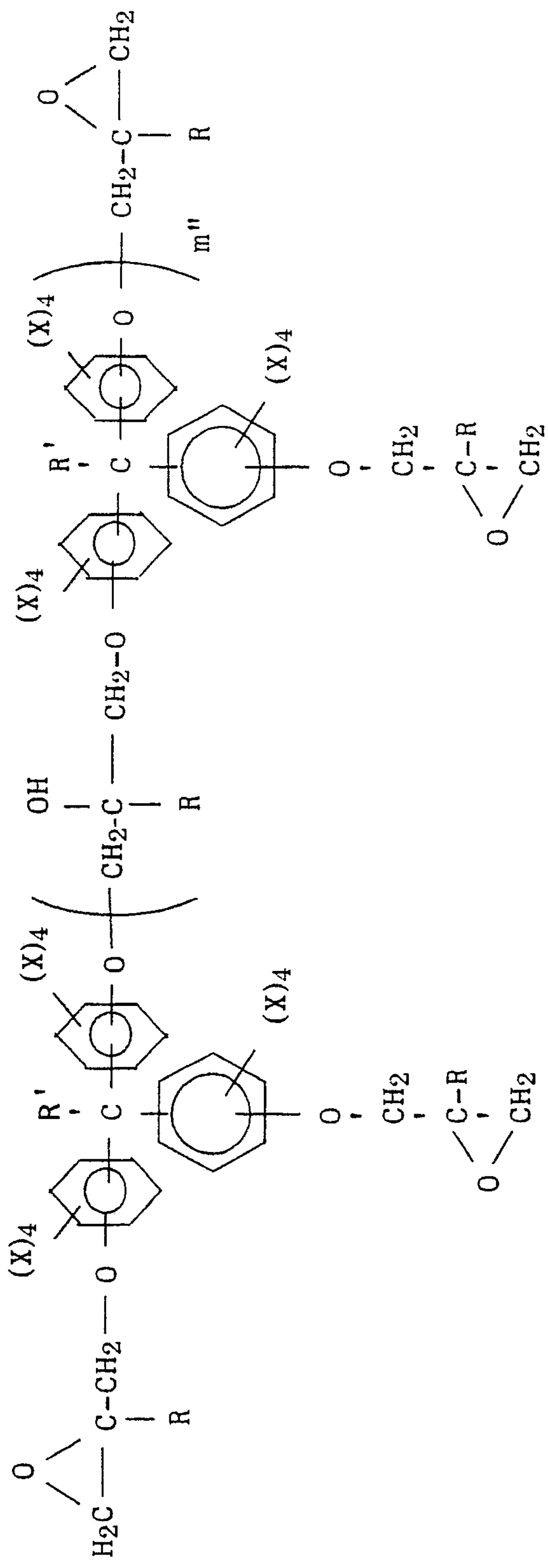

wherein each $A'$ is independently a divalent hydrocarbyl or substituted hydrocarbyl group having from 1 to 12 carbon atoms; each R is independently hydrogen or an alkyl group having from 1 to 4 carbon atoms; each $R'$ is independently hydrogen or a monovalent hydrocarbyl group or substituted monovalent hydrocarbyl group having from 1 to 4 carbon atoms; each X is independently hydrogen, a hydrocarbyl group or substituted hydrocarbyl group having from 1 to 10 carbon atoms, a halogen atom, or a nitro group; m has a value from 0.01 to 12 and $m''$ has an average value from zero to 10; and

(c) component (C) is a compound or mixture of compounds represented by the following formulas IV, V

or VI:

Formula IV

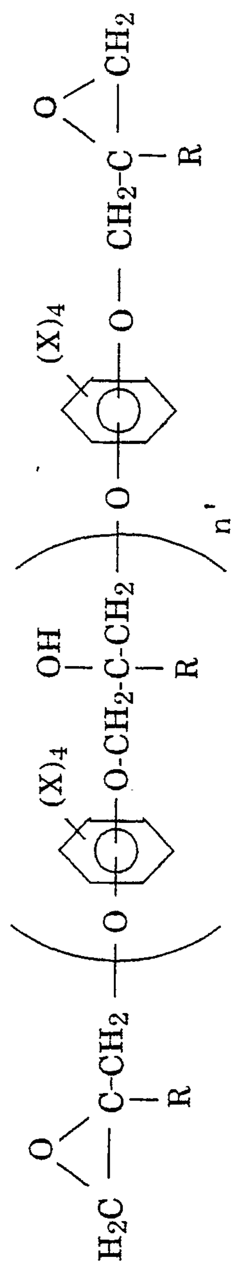

Formula V

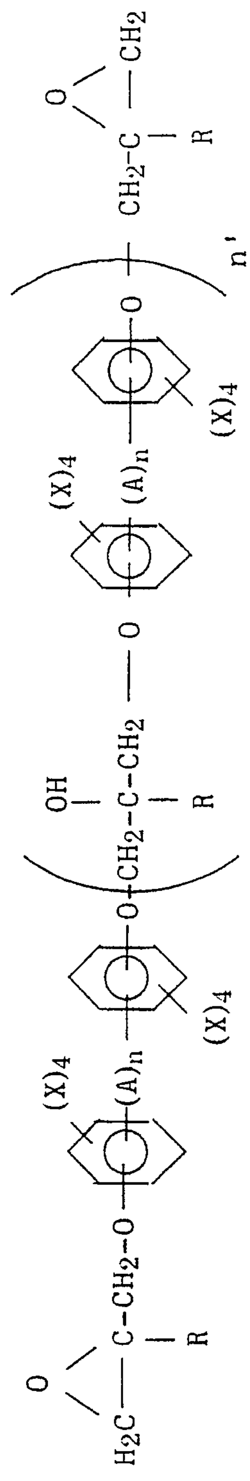

Formula VI

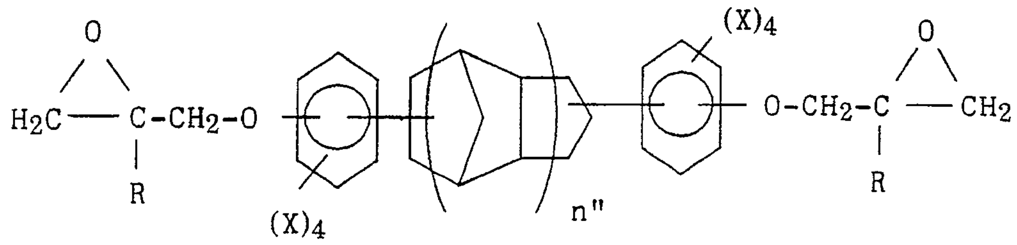

wherein A is a divalent hydrocarbyl group having from 1 to 12 carbon atoms, -O-, -S-, -S-S-, -SO-, $-SO_2-$, -CO- or -O-CO-O-; each R is independently hydrogen or an alkyl group having from 1 to 4 carbon atoms; each X is independently hydrogen, a hydrocarbyl group or substituted hydrocarbyl group having from 1 to 10 carbon atoms, a halogen atom, or a nitro group; n has a value of zero or 1; $n'$ has an average value from zero to 3; and $n''$ has an average value from 1 to 12.

4. A blend of Claim 3 wherein
(a) component (A) is a polyglycidyl ether of a dicyclopentadiene-phenol resin;
(b)component (B) is a phenol-formaldehyde epoxy novolac resin or a cresol-formaldehyde epoxy novolac resin;
(c)component (C), when present, is a diglycidyl ether of tetrabromo-bisphenol A; and
(d) component (D) is a copolymer of 2-ethylhexyl acrylate and glycidyl methacrylate rubber modified cresol-formaldehyde epoxy novolac resin.

5. A curable composition comprising
(I) a blend comprising
(A) at least one unsaturated hydrocarbon-phenol epoxy resin having an average of more than two vicinal epoxy groups per molecule;
(B) at least one compound having an average of more than two vicinal epoxy groups per molecule and which is different from component (A);
(C) optionally, at least one compound having an average of more than one, but not more than two vicinal epoxy groups per molecule; and
(D) at least one rubber or elastomer; and wherein component (C) is present in an amount such that from zero to less than 20 percent of the total amount of vicinal epoxy groups contained in components (A), (B) and (C) is contributed by component (C); and
(II)a curing amount of a suitable curing agent or curing catalyst for component (I).

6. A curable composition of Claim 5 wherein
(a) Component (A) is present in an amount of from 1 to 99 percent by weight based upon the combined amount of components (A) and (B);
(b) Component (B) is present in an amount of from 99 to 1 percent by weight based upon the combined amount of components (A) and (B);
(c) component (C) is present in an amount of from 1 to 20 percent of the total amount of vicinal epoxy groups contained in components (A), (B) and (C) is contributed by component (C); and
(d) component (D) is present in an amount of from 1 to 30 percent by weight based upon the combined weight of components (A), (B), (C) and (D).

7. A curable composition of Claim 5 wherein
(a) component (A) is a compound or mixture of compounds represented by the following general formula I:

Formula I

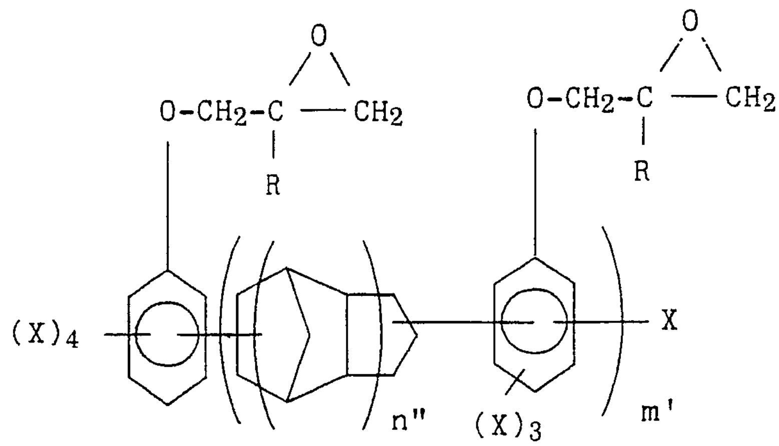

wherein each R is independently hydrogen or an alkyl group having from 1 to 4 carbon atoms; each X is independently hydrogen, a hydrocarbyl group or substituted hydrocarbyl group having from 1 to 10 carbon atoms, a halogen atom, or a nitro group; m′ has a value from 1.01 to 12; and n″ has an average value from 1 to 12;

(b) component (B) is a compound represented by the following general formulas II and III:

Formula II

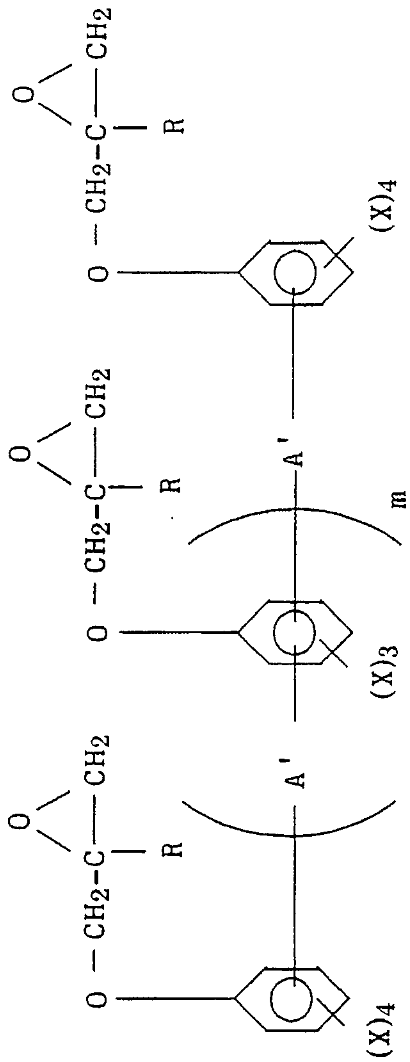

Formula III

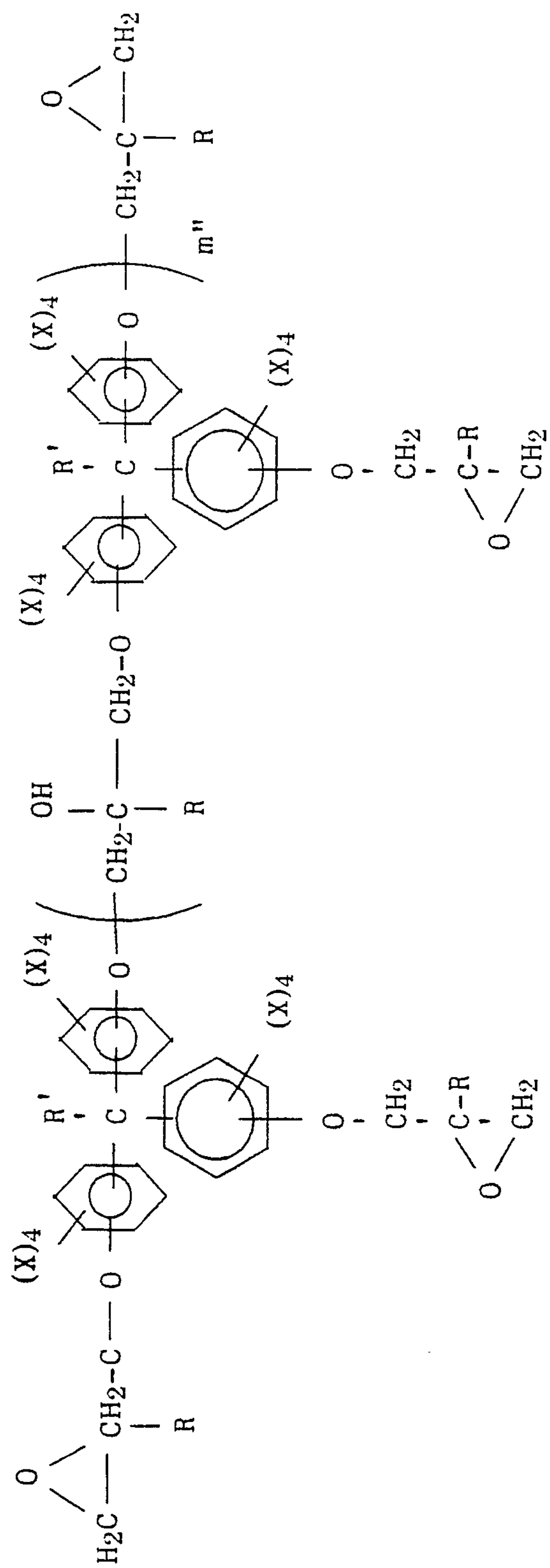

wherein each A′ is independently a divalent hydrocarbyl or substituted hydrocarbyl group having from 1 to 12 carbon atoms; each R is independently hydrogen or an alkyl group having from 1 to 4 carbon atoms; each R′ is independently hydrogen or a monovalent hydrocarbyl group or substituted monovalent hydrocarbyl group having from 1 to 4 carbon atoms; each X is independently hydrogen, a hydrocarbyl group or substituted hydrocarbyl group having from 1 to 10 carbon atoms, a halogen atom, or a nitro group; m has a value from 0.01 to 12 and m″ has an average value from zero to 10; and

(c) component (C) is a compound or mixture of compounds represented by the following formulas IV, V

or VI:

Formula IV

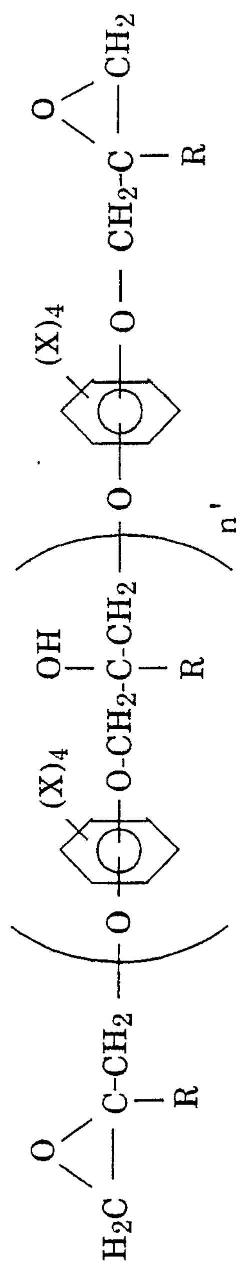

Formula V

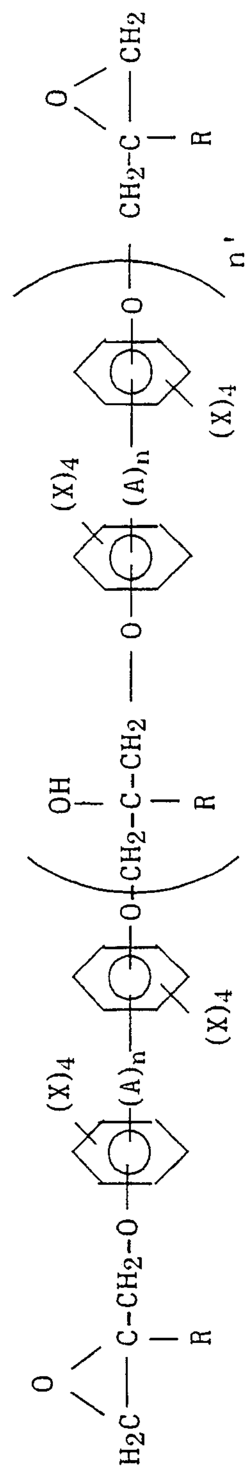

Formula VI

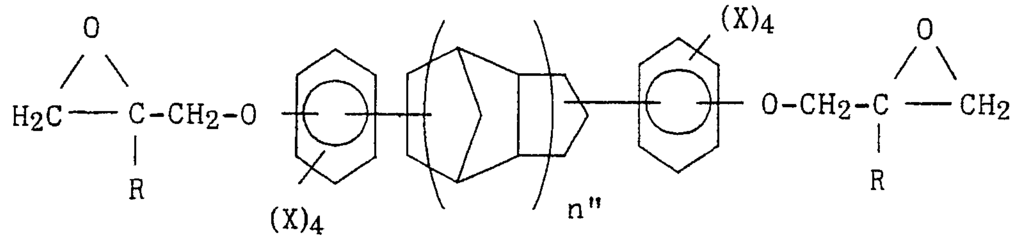

wherein A is a divalent hydrocarbyl group having from 1 to 12 carbon atoms, -O-, -S-, -S-S-, -SO-, $-SO_2-$, -CO-or -O-CO-O-; each R is independently hydrogen or an alkyl group having from 1 to 4 carbon atoms; each X is independently hydrogen, a hydrocarbyl group or substituted hydrocarbyl group having from 1 to 10 carbon atoms, a halogen atom, or a nitro group; n has a value of zero or 1; $n'$ has an average value from zero to 3; and $n''$ has an average value from 1 to about 12.

8. A curable composition of Claim 7 wherein
   (a) component (A) is a polyglycidyl ether of a dicyclopentadiene-phenol resin;
   (b) component (B) is a phenol-formaldehyde epoxy novolac resin or a cresol-formaldehyde epoxy novolac resin;
   (c) component (C), when present, is a diglycidyl ether of tetrabromo-bisphenol A; and
   (d) component (II) is a phenol-formaldehyde novolac resin, a cresol-formaldehyde resin, a dicyclopentadiene-phenol resin or a dicyclopentadiene-cresol phenol resin.

9. A curable composition of Claim 8 wherein component (D) is a copolymer of 2-ethylhexyl acrylate and glycidyl methacrylate.

10. The product resulting from curing the curable composition of Claim 5.

11. An electrical or electronic component encapsulated in a curable composition of Claim 5 which is subsequently cured.

12. A process for preparing a blend comprising mixing
   (A) at least one unsaturated hydrocarbon-phenol epoxy resin having an average of more than two vicinal epoxy groups per molecule;
   (B) at least one compound having an average of more than two vicinal epoxy groups per molecule and which is different from component (A);
   (C) optionally, at least one compound having an average of more than one, but not more than two vicinal epoxy groups per molecule; and
   (D) at least one rubber or elastomer; and wherein component (C), when present, is employed in an amount such that from 0 to less than 20 percent of the total amount of vicinal epoxy groups contained in components (A), (B) and (C) is contributed by component (C).

13. A process for preparing a curable composition comprising mixing (I) a blend comprising
   (A) at least one unsaturated hydrocarbon-phenol epoxy resin having an average of more than two vicinal epoxy groups per molecule;
   (B) at least one compound having an average of more than two vicinal epoxy groups per molecule and which is different from component (A);
   (C) optionally, at least one compound having an average of more than one, but not more than two vicinal epoxy groups per molecule; and
   (D) at least one rubber or elastomer; wherein component (C) is present in an amount such that from zero to less than 20 percent of the total amount of vicinal epoxy groups contained in components (A), (B) and (C) is contributed by component (C); and
   (II) a curing amount of a suitable curing agent or curing catalyst for component (I).

14. A process for preparing an electrical or electronic component encapsulated in a curable composition of Claim 5 comprising using the composition of Claim 5.